# EUROPEAN PATENT APPLICATION

(11) **EP 3 399 607 A1**
(43) Date of publication of application: **07.11.2018**
(21) Application number: 17169075.3
(22) Date of filing: 02.05.2017
(51) Int. Cl.: H01S 5/06, H01S 5/024, H01S 5/068, H01S 5/12

(54) **A METHOD OF WAVELENGTH TUNING FOR AN ONU AND AN ONU**

(71) Applicant: Nokia Solutions and Networks Oy, 02610 Espoo (FI)
(72) Inventor: Pöhlmann, Wolfgang, 70435 Stuttgart (DE); Brenot, Romain, 91767 Palaiseu Cedex (FR)
(74) Representative: Louis Pöhlau Lohrentz

(57) **Abstract**

The present invention discloses a method of wavelength tuning for an optical network unit, the optical network unit comprising: a distributed feedback laser, configured to emit an optical signal, wherein, a wavelength of the optical signal changes with a temperature of the distributed feedback laser; a temperature sensor, configured to determine the temperature of the distributed feedback laser; a thermoelectric cooler, TEC, unit, configured to adjust the temperature of the distributed feedback laser within a first tuning range based on a first time constant, a heater unit, configured to adjust the temperature of the distributed feedback laser within a second tuning range based on a second time constant, the second tuning range being not bigger than the first tuning range, and the second time constant being smaller than the first time constant; the method comprising steps of: driving the TEC unit with a first current I₁ and driving the heater unit with a second current I₂, so that the distributed feedback laser emits an optical signal with a first wavelength λ₁; receiving an indication of a second wavelength λ₂ to which the optical signal emitted by the distributed feedback laser shall be tuned; determining a third current I₃ for the TEC unit and a fourth current I₄ for the heater unit, so that the distributed feedback laser emits an optical signal with the second wavelength λ₂, when the TEC unit is driven by the third current I₃ and the heater unit is driven by the fourth current I₄; adjusting the current that is used to drive the TEC unit from the first current I₁ at a first time point t₁ to the third current I₃ at a second time point t₂, adjusting the current that is used to drive the heater unit, so that the temperature of the distributed feedback laser is kept constant from the first time point t₁ to the second time point t₂, the method further comprises a step of: tuning the wavelength of the optical signal emitted by the distributed feedback laser from the first wavelength λ₁ to the second wavelength λ₂ by adjusting the current that is used to drive the heater unit from the second current I₂ to a fifth current I₅ before the first time point, or from a fifth current I₅ to the fourth current I₄ after the second time point t₂.

## Description

### Field of the invention

The invention relates to communication technology, in particular to wavelength tuning in an optical communication system.

### Background

A key feature of time- and wavelength-division multiplexed passive optical network (TWDM PON) systems as next generation passive optical network 2 (NG-PON2) is the ability of an optical network unit (ONU) to tune its upstream laser to four or eight wavelength channels on a grid of 50/100 or 200GHz. As the ONU is very cost critical, a low cost tuning scheme as thermal tuning is normally used to perform this tuning. With thermal tuning, four or eight channels on a 50 or 100 GHz grid can be covered. Traditionally this tuning is performed with a thermal electrical cooler (TEC), what can heat or cool. The disadvantage of the TEC is that tuning to another channel needs one second (1 s) or more tuning time, what can be in best case a tuning class 3 from ITU-T G.989.2.

This means that the ONU will need to re-register in the new wavelength channel. There is a request from operators to allow also faster wavelength tuning according to class 2 which means a max. tuning time of 25ms. With this short tuning time, no re-registration in the new wavelength channel is required, which makes it also attractive for load balancing or protection switching.

Current class 2 solutions rely e.g. on distributed Bragg reflector (DBR) lasers. The wavelength in these lasers is not tuned by temperature, but by current injection in special laser sections. This allows much faster tuning speed than thermal tuning with TECs. But these lasers consist of multiple sections, which makes it complicated and costly to manufacture and to tune these devices. Besides, mode-hop free operation can also be a challenge. Therefore the cost of this solution is higher than simple thermal tuning.

An object of the invention is to provide a fast tuning scheme with low cost in an ONU.

### Summary of the Invention

The object of the invention is achieved by the method and the ONU in the claims.

According to one aspect of the invention, there is provided a method of wavelength tuning for an optical network unit, the optical network unit comprising: a distributed feedback laser, configured to emit an optical signal, wherein, a wavelength of the optical signal changes with a temperature of the distributed feedback laser; a temperature sensor, configured to determine the temperature of the distributed feedback laser; a thermoelectric cooler, TEC, unit, configured to adjust the temperature of the distributed feedback laser within a first tuning range based on a first time constant, a heater unit, configured to adjust the temperature of the distributed feedback laser within a second tuning range based on a second time constant, the second tuning range being not bigger than the first tuning range, and the second time constant being smaller than the first time constant; the method comprising steps of: driving the TEC unit with a first current I₁ and driving the heater unit with a second current I₂, so that the distributed feedback laser emits an optical signal with a first wavelength λ₁; receiving an indication of a second wavelength λ₂ to which the optical signal emitted by the distributed feedback laser shall be tuned; determining a third current I₃ for the TEC unit and a fourth current I₄ for the heater unit, so that the distributed feedback laser emits an optical signal with the second wavelength λ₂, when the TEC unit is driven by the third current I₃ and the heater unit is driven by the fourth current I₄; adjusting the current that is used to drive the TEC unit from the first current I₁ at a first time point t₁ to the third current I₃ at a second time point t₂, adjusting the current that is used to drive the heater unit, so that the temperature of the distributed feedback laser is kept constant from the first time point t₁ to the second time point t₂, the method further comprises a step of: tuning the wavelength of the optical signal emitted by the distributed feedback laser from the first wavelength λ₁ to the second wavelength λ₂ by adjusting the current that is used to drive the heater unit from the second current I₂ to a fifth current I₅ before the first time point, or from a fifth current I₅ to the fourth current I₄ after the second time point t₂.

In a preferred embodiment of the invention, a duration from the first time point t₁ to the second time point t₂ is not less than 1 s.

In a preferred embodiment of the invention, the third current I₃ of the TEC unit being smaller than the first current I₁ of the TEC unit, if the second wavelength λ₂ is smaller than the first wavelength λ₁, the method further comprising: reducing the current that is used to drive the TEC unit from the first current I₁ at the first time point t₁ to the third current I₃ at the second time point t₂; increasing the current that is used to drive the heater unit from the second current I₂ at the first time point t₁ to a fifth current I₅ at the second time point t₂, so that the temperature of the distributed feedback laser is kept constant from the first time point t₁ to the second time point t₂; and reducing the current that is used to drive the heater unit from the fifth current I₅ to the fourth current I₄ after the second time point t₂, so that the wavelength of the optical signal emitted by the distributed feedback laser is reduced to the second wavelength λ₂ after a tuning time.

In a preferred embodiment of the invention, the third current I₃ of the TEC unit being higher than the first current I₁ of the TEC unit, if the second wavelength λ₂ is greater than the first wavelength λ₁, the method further comprising: increasing the current that is used to drive the heater unit from the second current I₂ to the fifth current I₅, so that the wavelength of the optical signal emitted by the distributed feedback laser is increased to the second wavelength λ₂ after a tuning time; and then increasing the current that is used to drive the TEC unit from the first current I₁ at the first time point t₁ to the third current I₃ at the second time point t₂; and reducing the current that is used to drive the heater unit from the fifth current I₅ at the first time point t₁ to the fourth current I₄ at the second time point t₂, so that the temperature of the distributed feedback laser is kept constant from the first time point t₁ to the second time point t₂.

In a preferred embodiment of the invention, the tuning time is not greater than 25 ms.

In a preferred embodiment of the invention, the first current I₁ and the second current I₂ are 0.

In a preferred embodiment of the invention, the first tuning range is 400 GHz and the second tuning range is 100 GHz.

In a preferred embodiment of the invention, the second current I₂ and the fourth current I₄ are 0.

In a preferred embodiment of the invention, a deviation from the first wavelength λ₁ to the second wavelength λ₂ is within the second tuning range.

According to another aspect of the invention, there is provided an optical network unit comprising: a distributed feedback laser, configured to emit an optical signal, wherein, a wavelength of the optical signal changes with a temperature of the distributed feedback laser; a temperature sensor, configured to determine the temperature of the distributed feedback laser; a thermoelectric cooler, TEC, unit, configured to adjust the temperature of the distributed feedback laser within a first tuning range based on a first time constant, a heater unit, configured to adjust the temperature of the distributed feedback laser within a second tuning range based on a second time constant, the second tuning range being not bigger than the first tuning range, and the second time constant being smaller than the first time constant; a control circuit, configured to: drive the TEC unit with a first current I₁ and driving the heater unit with a second current I₂, so that the distributed feedback laser emits an optical signal with a first wavelength λ₁; receive an indication of a second wavelength λ₂ to which the optical signal emitted by the distributed feedback laser shall be tuned; determine a third current I₃ for the TEC unit and a fourth current I₄ for the heater unit, so that the distributed feedback laser emits an optical signal with the second wavelength λ₂, when the TEC unit is driven by the third current I₃ and the heater unit is driven by the fourth current I₄; adjust the current that is used to drive the TEC unit from the first current I₁ at a first time point t₁ to the third current I₃ at a second time point t₂, adjust the current that is used to drive the heater unit, so that the temperature of the distributed feedback laser is kept constant from the first time point t₁ to the second time point t₂, the control circuit being further configured to: tune the wavelength of the optical signal emitted by the distributed feedback laser from the first wavelength λ₁ to the second wavelength λ₂ by adjusting the current that is used to drive the heater unit from the second current I₂ to a fifth current I₅ before the first time point, or from a fifth current I₅ to the fourth current I₄ after the second time point t₂.

In a preferred embodiment of the invention, a duration from the first time point t₁ to the second time point t₂ is not less than 1 s.

In a preferred embodiment of the invention, the third current I₃ of the TEC unit being smaller than the first current I₁ of the TEC unit, if the second wavelength λ₂ is smaller than the first wavelength λ₁, the control circuit being further configured to: reduce the current that is used to drive the TEC unit from the first current I₁ at the first time point t₁ to the third current I₃ at the second time point t₂; increase the current that is used to drive the heater unit from the second current I₂ at the first time point t₁ to a fifth current I₅ at the second time point t₂, so that the temperature of the distributed feedback laser is kept constant from the first time point t₁ to the second time point t₂; and reduce the current that is used to drive the heater unit from the fifth current I₅ to the fourth current I₄ after the second time point t₂, so that the wavelength of the optical signal emitted by the distributed feedback laser is reduced to the second wavelength λ₂ after a tuning time.

In a preferred embodiment of the invention, the third current I₃ of the TEC unit being higher than the first current I₁ of the TEC unit, if the second wavelength λ₂ is greater than the first wavelength λ₁, the control circuit being further configured to: increase the current that is used to drive the heater unit from the second current I₂ to the fifth current I₅, so that the wavelength of the optical signal emitted by the distributed feedback laser is increased to the second wavelength λ₂ after a tuning time; and then increase the current that is used to drive the TEC unit from the first current I₁ at the first time point t₁ to the third current I₃ at the second time point t₂; and reduce the current that is used to drive the heater unit from the fifth current I₅ at the first time point t₁ to the fourth current I₄ at the second time point t₂, so that the temperature of the distributed feedback laser is kept constant from the first time point t₁ to the second time point t₂.

In a preferred embodiment of the invention, the first tuning range is 400GHz and the second tuning range is 100 GHz.

In a preferred embodiment of the invention, a deviation from the first wavelength λ₁ to the second wavelength λ₂ is within the second tuning range.

According to the present invention, the combination of the TEC unit and the heater makes it possible to provide a fast tuning while ensuring a stabilized temperature. The tuning time can be reduced to a range within class 2 with a low cost of the ONU.

### Brief description of the figures

The features and advantages of the invention will be more completely understood by appreciating the following detailed description of preferred embodiments with reference to the figures, wherein
Fig. 1 depicts a schematic block diagram of an ONU 100 according to an embodiment of the present invention;
Fig. 2 depicts a schematic diagram of a tuning process according to an embodiment of the present invention;
Fig. 3 depicts a schematic diagram of a tuning process according to another embodiment of the present invention.

### Detailed description

Exemplary embodiments of the present application are described herein in detail and shown by way of example in the drawings. It should be understood that, although specific exemplary embodiments are discussed herein there is no intent to limit the scope of the invention to such embodiments. To the contrary, it should be understood that the exemplary embodiments discussed herein are for illustrative purposes, and that modified and alternative embodiments may be implemented without departing from the scope of the invention. Similarly, specific structural and functional details disclosed herein are merely representative for purposes of describing the exemplary embodiments. The invention described herein, however, may be embodied in many alternate forms and should not be construed as limited to only the embodiments set forth herein.

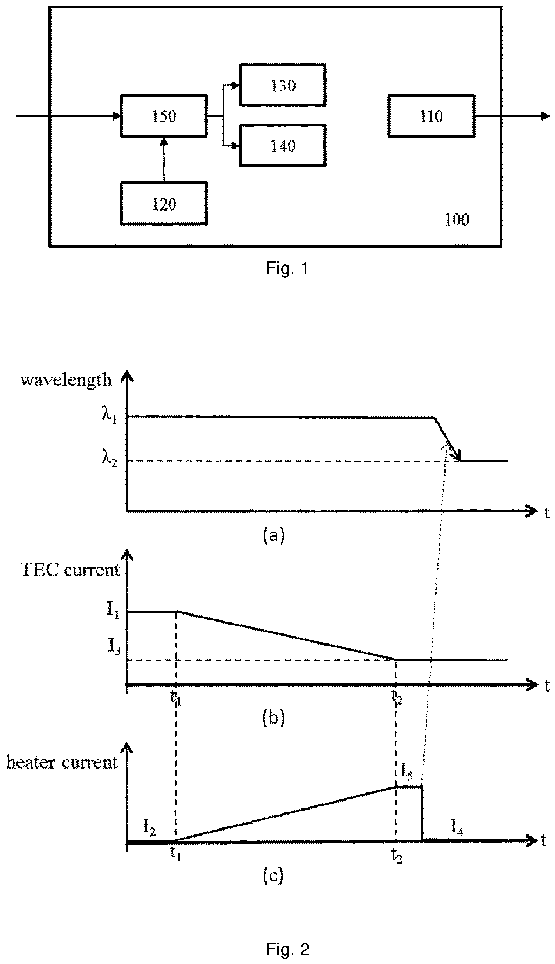

Fig.1 shows a schematic block diagram of an ONU 100 according to an embodiment of the present invention. The ONU 100 comprises a distributed feedback (DFB) laser 110, a temperature sensor 120, a TEC unit 130, an on-chip heater unit 140, and a control circuit 150.

The DFB laser 110 is configured to emit an optical signal, wherein, the wavelength of the optical signal changes with the temperature of the DFB laser.

A property of the DFB laser 110 is that the temperature of the laser is proportional to the wavelength of the optical signal emitted by the laser. In one embodiment, the temperatures of the laser 110 changes for 8K, and the wavelength of the optical signal emitted by the laser 110 changes for 100 GHz.

Therefore, there is configured a temperature sensor 120 to determine the temperature of the DFB laser 110, so as to determine the wavelength of the optical signal emitted by the laser 110. An on-chip temperature sensor would be preferred, but if it is not available a well placed off-chip sensor can also be sufficient.

The TEC unit 130 is configured to adjust the temperature of the DFB laser within a first tuning range based on a first time constant. The TEC unit 130 may cool or heat the DFB laser 110, therefore can increase and reduce the emitted wavelength, but with a slow time constant in the range of second(s). In the following, the embodiments of the present invention will be described assuming that the TEC unit 130 has a first tuning range sufficient to tune over a full range of e.g. 400GHz.

The heater unit 140 is configured to adjust the temperature of the DFB laser 110 within a second tuning range based on a second time constant, the second tuning range being not bigger than the first tuning range, and the second time constant being smaller than the first time constant. In one embodiment, the heater unit 140 can heat the DFB laser unit 110 and therefore increase the wavelength of the laser with a fast time constant in range of a few milliseconds or less.

It is known that using on-chip heater unit alone to tune over a full range of e.g. 400GHz would require very powerful heaters that are very closely spaced to the active area on the laser chip. Therefore there is a trade off in the design between heater power (area of heater stripe) and time constant of the heater (closer is faster). In an embodiment, the second tuning range is large enough to tune over a range between the channel with smallest wavelength and the channel with the largest wavelength. In another embodiment, the tuning range of the heater unit 140 is not sufficient to tune over all channels, but at least large enough to tune over one channel. In the following, the embodiments of the present invention will be described assuming that the first tuning range is 400GHz, the second tuning range is 100 GHz, and the grid between two adjacent channels is 100 GHz.

A skilled person shall understand that the second tuning range limits the class 2 tuning range of the ONU according to the present application. For example, if the second tuning range is large enough to tune the wavelength of the optical signal emitted by the ONU over one channel, the tuning within one channel range can be accomplished within 25 ms (class 2 according to ITU-T G.989.2). If the second tuning range is large enough to tune over two channels, the tuning within two channels range can be accomplished within 25 ms (class 2 according to ITU-T G.989.2).

The control circuit 150 is configured to receive an indication of a wavelength and adjust the current that is used to drive the TEC unit 130 and the heater unit 140 according to the feedback from the temperature sensor 120, so that the DFB laser 110 emits an optical signal with the indicated wavelength.

Fig. 2 shows a schematic diagram of a tuning process according to an embodiment of the present invention.

In the embodiment shown in Fig. 2, the wavelength of the optical signal emitted by the DFB laser 110 is tuned from a first wavelength λ₁ to a second wavelength λ₂. The second wavelength λ₂ is smaller than the first wavelength λ₁, λ₂<λ₁.

Before the tuning process starts, the TEC unit 130 is driven with a first current I₁ and the heater unit 140 is driven with a second current I₂, so that the distributed feedback laser 110 emits an optical signal with the first wavelength λ₁.

Shortly before a first time point t₁, the control circuit 150 receives an indication of the second wavelength λ₂ to which the optical signal emitted by the DFB laser 110 shall be tuned. The control circuit 150 determines a third current I₃ for the TEC unit 130 and a fourth current I₄ for the heater unit 140, so that the DFB laser 110 emits an optical signal with the second wavelength λ₂, when the TEC unit 130 is driven by the third current I₃ and the heater unit 140 is driven by the fourth current I₄. The third current I₃ and the fourth current I₄ may be determined according to historical value for example a lookup-table. A skilled person shall understand the third current I₃ and the fourth current I₄ may be further adjusted according to the feedback from the temperature sensor 120.

The control circuit 150 adjusts the current that is used to drive the TEC unit 130 from the first current I₁ at the first time point t₁ to the third current I₃ at a second time point t₂, and adjusts the current that is used to drive the heater unit 140, so that the temperature of the DFB laser 110 is kept constant from the first time point t₁ to the second time point t₂. Thus, the wavelength of the optical signal emitted by the DFB laser 110 is also kept constant from the first time point t₁ to the second time point t₂.

Specifically, in the embodiment shown in Fig. 2, the third current I₃ of the TEC unit 130 is smaller than the first current I₁ of the TEC unit 130, the current that is used to drive the TEC unit 130 is reduced from the first current I₁ at the first time point t₁ to the third current I₃ at the second time point t₂. The current that is used to drive the heater unit 140 is increased from the second current I₂ at the first time point t₁ to a fifth current I₅ at the second time point t₂, so that the temperature of the DFB laser 110 is kept constant from the first time point t₁ to the second time point t₂. A duration from the first time point t₁ to the second time point t₂ is related to the tuning time of the TEC unit 130, in a preferred embodiment, not less than 1 s.

Then the current that is used to drive the heater unit 140 is reduced from the fifth current I₅ to the fourth current I₄ after the second time point t₂, so that the wavelength of the optical signal emitted by the DFB laser 110 is reduced from the first wavelength λ₁ to the second wavelength λ₂ after a tuning time.

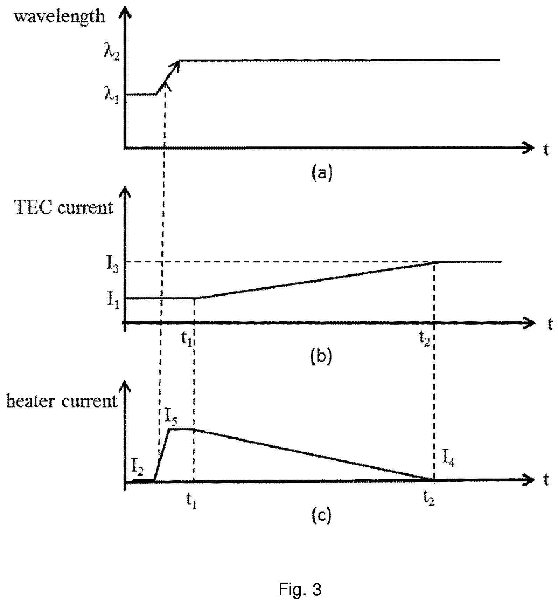

Fig. 3 shows a schematic diagram of a tuning process according to another embodiment of the present invention.

In the embodiment shown in Fig. 3, the wavelength of the optical signal emitted by the DFB laser 110 is tuned from a first wavelength λ₁ to a second wavelength λ₂. The second wavelength λ₂ is greater than the first wavelength λ₁, λ₂>λ₁.

Before the tuning process starts, the TEC unit 130 is driven with a first current I₁ and the heater unit 140 is driven with a second current I₂, so that the distributed feedback laser 110 emits an optical signal with the first wavelength λ₁.

The tuning process may start shortly after the control circuit 150 receives an indication of the second wavelength λ₂ to which the optical signal emitted by the DFB laser 110 shall be tuned. The control circuit 150 may also determine the third current I₃ for the TEC unit 130 and the fourth current I₄ for the heater unit 140 as it is described above with respect to Fig. 2. Specifically, in the embodiment shown in Fig. 3, the third current I₃ of the TEC unit 130 is higher than the first current I₁ of the TEC unit 130.

In the embodiment shown in Fig. 3, at the beginning of the tuning process, the current that is used to drive the heater unit 140 is increased from the second current I₂ to the fifth current I₅, so that the wavelength of the optical signal emitted by the DFB laser 110 is increased to the second wavelength λ₂ after a tuning time; and then the current that is used to drive the TEC unit 130 is increased from the first current I₁ at the first time point t₁ to the third current I₃ at the second time point t₂; meanwhile, the current that is used to drive the heater unit 140 is reduced from the fifth current I₅ at the first time point t₁ to the fourth current I₄ at the second time point t₂, so that the temperature of the DFB laser 110 is kept constant from the first time point t₁ to the second time point t₂.

According to the method proposed in the present invention, the tuning time for tuning the wavelength of the optical signal emitted by the DFB laser 110 from λ₁ to λ₂ is not greater than 25ms. A class 2 tuning can be achieved with very low cost.

In the embodiments shown in Fig. 2 and Fig. 3, the second current I₂ and the fourth current I₄ are 0. It is simple and energy efficient to determine the second current I₂ and the fourth current I₄ as 0. However, a skilled person shall understand the value of the second current I₂ and the fourth current I₄ shall not be limited to the given example, other non-zero values are also possible. For example, if the duration from the first time point t₁ to the second time point t₂ is shorter than the tuning time of the TEC unit 130, the second current I₂ and the fourth current I₄ may be non-zero values.

The present invention can also be used to initialize the ONU 100, in that case, the first current I₁ and the second current I₂ are 0.

In the embodiments shown in Fig. 2 and Fig. 3, a deviation from the first wavelength λ₁ to the second wavelength λ₂ is within the second tuning range, so that the tuning time can be limited within 25ms. In another embodiment, if the deviation from the first wavelength λ₁ to the second wavelength λ₂ is beyond the second tuning range, the procedure described earlier with respect to Fig. 2 or Fig. 3 may be repeated to finish the tuning in more than one hop.

## Claims

1. A method of wavelength tuning for an optical network unit (100), the optical network unit (100) comprising:
a distributed feedback laser (110), configured to emit an optical signal, wherein, a wavelength of the optical signal changes with a temperature of the distributed feedback laser;
a temperature sensor (120), configured to determine the temperature of the distributed feedback laser (110);
a thermoelectric cooler, TEC, unit (130), configured to adjust the temperature of the distributed feedback laser (110) within a first tuning range based on a first time constant,
a heater unit (140), configured to adjust the temperature of the distributed feedback laser (110) within a second tuning range based on a second time constant, the second tuning range being not bigger than the first tuning range, and the second time constant being smaller than the first time constant;
the method comprising steps of:
- driving the TEC unit (130) with a first current I₁ and driving the heater unit (140) with a second current I₂, so that the distributed feedback laser (110) emits an optical signal with a first wavelength λ₁;
- receiving an indication of a second wavelength λ₂ to which the optical signal emitted by the distributed feedback laser (110) shall be tuned;
- determining a third current I₃ for the TEC unit (130) and a fourth current I₄ for the heater unit (140), so that the distributed feedback laser (110) emits an optical signal with the second wavelength λ₂, when the TEC unit (130) is driven by the third current I₃ and the heater unit (140) is driven by the fourth current I₄;
- adjusting the current that is used to drive the TEC unit (130) from the first current I₁ at a first time point t₁ to the third current I₃ at a second time point t₂,
- adjusting the current that is used to drive the heater unit (140), so that the temperature of the distributed feedback laser (110) is kept constant from the first time point t₁ to the second time point t₂,
the method further comprises a step of:
- tuning the wavelength of the optical signal emitted by the distributed feedback laser (110) from the first wavelength λ₁ to the second wavelength λ₂ by adjusting the current that is used to drive the heater unit (140) from the second current I₂ to a fifth current I₅ before the first time point, or from a fifth current I₅ to the fourth current I₄ after the second time point t₂.

2. A method according to claim 1, wherein, a duration from the first time point t₁ to the second time point t₂ is not less than 1 s.

3. A method according to claim 1, the third current I₃ of the TEC unit (130) being smaller than the first current I₁ of the TEC unit (130), if the second wavelength λ₂ is smaller than the first wavelength λ₁,
the method further comprising:
reducing the current that is used to drive the TEC unit (130) from the first current I₁ at the first time point t₁ to the third current I₃ at the second time point t₂;
increasing the current that is used to drive the heater unit (140) from the second current I₂ at the first time point t₁ to a fifth current I₅ at the second time point t₂, so that the temperature of the distributed feedback laser (110) is kept constant from the first time point t₁ to the second time point t₂; and
reducing the current that is used to drive the heater unit (140) from the fifth current I₅ to the fourth current I₄ after the second time point t₂, so that the wavelength of the optical signal emitted by the distributed feedback laser (110) is reduced to the second wavelength λ₂ after a tuning time.

4. A method according to claim 1, the third current I₃ of the TEC unit (130) being higher than the first current I₁ of the TEC unit (130), if the second wavelength λ₂ is greater than the first wavelength λ₁,
the method further comprising:
increasing the current that is used to drive the heater unit (140) from the second current I₂ to the fifth current I₅, so that the wavelength of the optical signal emitted by the distributed feedback laser (110) is increased to the second wavelength λ₂ after a tuning time; and then
increasing the current that is used to drive the TEC unit (130) from the first current I₁ at the first time point t₁ to the third current I₃ at the second time point t₂; and
reducing the current that is used to drive the heater unit (140) from the fifth current I₅ at the first time point t₁ to the fourth current I₄ at the second time point t₂, so that the temperature of the distributed feedback laser (110) is kept constant from the first time point t₁ to the second time point t₂.

5. A method according to claim 3 or 4, wherein, the tuning time is not greater than 25ms.

6. A method according to claim 4, the first current I₁ and the second current I₂ are 0.

7. A method according to claim 1, wherein, the first tuning range is 400GHz and the second tuning range is 100 GHz.

8. A method according to claim 1, wherein, the second current I₂ and the fourth current I₄ are 0.

9. A method according to claim 1, wherein, a deviation from the first wavelength λ₁ to the second wavelength λ₂ is within the second tuning range.

10. An optical network unit (100) comprising:
a distributed feedback laser (110), configured to emit an optical signal, wherein, a wavelength of the optical signal changes with a temperature of the distributed feedback laser;
a temperature sensor (120), configured to determine the temperature of the distributed feedback laser (110);
a thermoelectric cooler, TEC, unit (130), configured to adjust the temperature of the distributed feedback laser (110) within a first tuning range based on a first time constant,
a heater unit (140), configured to adjust the temperature of the distributed feedback laser (110) within a second tuning range based on a second time constant, the second tuning range being not bigger than the first tuning range, and the second time constant being smaller than the first time constant;
a control circuit (150), configured to:
- drive the TEC unit (130) with a first current I₁ and driving the heater unit (140) with a second current I₂, so that the distributed feedback laser (110) emits an optical signal with a first wavelength λ₁;
- receive an indication of a second wavelength λ₂ to which the optical signal emitted by the distributed feedback laser (110) shall be tuned;
- determine a third current I₃ for the TEC unit (130) and a fourth current I₄ for the heater unit (140), so that the distributed feedback laser (110) emits an optical signal with the second wavelength λ₂, when the TEC unit (130) is driven by the third current I₃ and the heater unit (140) is driven by the fourth current I₄;
- adjust the current that is used to drive the TEC unit (130) from the first current I₁ at a first time point t₁ to the third current I₃ at a second time point t₂,
- adjust the current that is used to drive the heater unit (140), so that the temperature of the distributed feedback laser (110) is kept constant from the first time point t₁ to the second time point t₂,
the control circuit (150) being further configured to:
- tune the wavelength of the optical signal emitted by the distributed feedback laser (110) from the first wavelength λ₁ to the second wavelength λ₂ by adjusting the current that is used to drive the heater unit (140) from the second current I₂ to a fifth current I₅ before the first time point, or from a fifth current I₅ to the fourth current I₄ after the second time point t₂.

11. An optical network unit (100) according to claim 10, wherein, a duration from the first time point t₁ to the second time point t₂ is not less than 1 s.

12. An optical network unit (100) according to claim 10, the third current I₃ of the TEC unit (130) being smaller than the first current I₁ of the TEC unit (130), if the second wavelength λ₂ is smaller than the first wavelength λ₁,
the control circuit (150) being further configured to:
- reduce the current that is used to drive the TEC unit (130) from the first current I₁ at the first time point t₁ to the third current I₃ at the second time point t₂;
- increase the current that is used to drive the heater unit (140) from the second current I₂ at the first time point t₁ to a fifth current I₅ at the second time point t₂, so that the temperature of the distributed feedback laser (110) is kept constant from the first time point t₁ to the second time point t₂; and
- reduce the current that is used to drive the heater unit (140) from the fifth current I₅ to the fourth current I₄ after the second time point t₂, so that the wavelength of the optical signal emitted by the distributed feedback laser (110) is reduced to the second wavelength λ₂ after a tuning time.

13. An optical network unit (100) according to claim 10, the third current I₃ of the TEC unit (130) being higher than the first current I₁ of the TEC unit (130), if the second wavelength λ₂ is greater than the first wavelength λ₁,
the control circuit (150) being further configured to:
- increase the current that is used to drive the heater unit (140) from the second current I₂ to the fifth current I₅, so that the wavelength of the optical signal emitted by the distributed feedback laser (110) is increased to the second wavelength λ₂ after a tuning time; and then
- increase the current that is used to drive the TEC unit (130) from the first current I₁ at the first time point t₁ to the third current I₃ at the second time point t₂; and
- reduce the current that is used to drive the heater unit (140) from the fifth current I₅ at the first time point t₁ to the fourth current I₄ at the second time point t₂, so that the temperature of the distributed feedback laser (110) is kept constant from the first time point t₁ to the second time point t₂.

14. An optical network unit (100) according to claim 10, wherein, the first tuning range is 400GHz and the second tuning range is 100 GHz.

15. An optical network unit (100) according to claim 10, wherein, a deviation from the first wavelength λ₁ to the second wavelength λ₂ is within the second tuning range.
